Europäisches Patentamt

European Patent Office

Office européen des brevets

(19)

(11) EP 0 709 959 B1

(12) **FASCICULE DE BREVET EUROPEEN**

(45) Date de publication et mention
de la délivrance du brevet:
**29.12.1999 Bulletin 1999/52**

(51) Int Cl.⁶: **H03J 7/02**, H03D 3/00

(21) Numéro de dépôt: 95402355.2

(22) Date de dépôt: 23.10.1995

(54) **Correction d'un décalage de fréquence**

Vorrichtung zur Korrektur einer Frequenzverschiebung

Correction of a frequency offset

(84) Etats contractants désignés:
**AT BE CH DE DK ES FR GB IT LI NL SE**

(30) Priorité: **25.10.1994 FR 9412738**

(43) Date de publication de la demande:
**01.05.1996 Bulletin 1996/18**

(73) Titulaire: **ALCATEL**
**75008 Paris (FR)**

(72) Inventeurs:
• **Auvray, Gérard**
**F-95870 Bezons (FR)**
• **Perron, Olivier**
**F-95130 Franconville (FR)**

(74) Mandataire: **Lamoureux, Bernard et al**
**COMPAGNIE FINANCIERE ALCATEL**
**Dépt. Propriété industrielle**
**30, avenue Kléber**
**75116 Paris (FR)**

(56) Documents cités:
**EP-A- 0 500 025          US-A- 4 647 864**

## Description

Le domaine de l'invention est celui de la correction d'un décalage de fréquence entre un signal de réception et un signal de référence.

Dans un système de transmission, un émetteur émet un signal d'émission qui, après être passé dans un canal de transmission, donne lieu à un signal de réception reçu dans un récepteur. Le récepteur est accordé sur une fréquence de référence qui correspond à la fréquence du signal d'émission. Cependant, il peut arriver que la fréquence du signal de réception soit décalée par rapport à la fréquence de référence. Ce décalage va provoquer une dégradation de l'information supportée par le signal de réception au cours du traitement de ce signal dans le récepteur. Il doit donc être corrigé.

Afin de bien faire ressortir les problèmes que soulève cette correction, on considèrera, à titre illustratif, un système de radiocommunication. Dans un tel système, le signal de réception est un signal radiofréquence. Ce signal peut présenter un décalage de fréquence avec le signal de référence généré localement dans le récepteur du fait que les horloges de l'émetteur et du récepteur ne sont pas synchronisés. De plus, si le récepteur se déplace à une vitesse relativement élevée, l'effet Doppler va lui aussi contribuer à ce décalage de fréquence. On comprend aisément que l'effet Doppler aura une influence encore plus considérable dans les systèmes utilisant des satellites. On prendra pour exemple le cas des satellites défilant en orbite basse ou le décalage de fréquence dû à ce phénomène peut varier de + 45 kHz à - 45 kHz pour un signal de réception de 2,5 GHz.

Les récepteurs comprennent généralement un convertisseur de fréquence qui reçoit le signal de réception et un signal de conversion pour produire un signal de transposition. Ce dernier signal est un signal à fréquence intermédiaire ou un signal en bande de base.

Le signal de conversion est produit par un oscillateur local, un synthétiseur de fréquences par exemple, en réponse à un signal de commande.

Une première solution pour corriger le décalage de fréquence consiste à utiliser une boucle à verrouillage de phase.

Selon cette technique connue, on agit directement sur le signal de commande de l'oscillateur local. Il s'ensuit que celui-ci doit pouvoir produire un signal de conversion avec une fréquence dont la précision est au moins égale à celle que l'on attend de la correction.

Cette technique est relativement coûteuse à mettre en oeuvre.

Elle est par ailleurs mal adaptée aux systèmes à accès multiple par répartition dans le temps dans lesquels le signal de réception se présente sous la forme d'une succession de paquets ou rafales émis périodiquement dans des intervalles de temps de durée constante. En effet, le temps de verrouillage de la boucle peut n'être pas négligeable vis-à-vis de la durée des intervalles de temps.

Pour s'affranchir des contraintes de cette première solution, une deuxième solution a été développée selon laquelle on fixe la fréquence du signal de conversion égale à celle du signal de référence qui est la valeur théorique de celle du signal de réception.

Généralement, le signal de transposition a fait l'objet d'une conversion analogique numérique suite à la conversion de fréquence, si bien que l'on peut corriger le décalage de fréquence par un traitement numérique lorsque la valeur de ce décalage est connue. Lorsque le décalage est important, le signal de transposition présente une fréquence sensiblement différente de celle qu'il aurait en l'absence de tout décalage. Ce n'est pas souhaitable, notamment lorsque l'on prévoit un filtrage de canal à la suite de la conversion de fréquence. En effet, le filtre correspondant est accordé sur une fréquence centrale qui correspond à un décalage de fréquence nul. Lorsque le signal de transposition s'écarte de cette fréquence centrale, il peut arriver en bout de bande du filtre.

En tout état de cause, les performances de ce filtre seront dégradées. Il en est ainsi notamment de la linéarité en fréquence, du taux d'erreur.

La présente invention a ainsi pour objet de proposer une correction d'un décalage de fréquence entre un signal de réception et un signal de référence optimisée tant au niveau des performances que du coût.

A cet effet, le dispositif de correction d'un décalage de fréquence entre un signal de réception et un signal de référence s'applique lorsque ce signal de réception est soumis à un convertisseur de fréquence qui reçoit également un signal de conversion pour produire un signal de transposition, ce signal de conversion étant produit par un oscillateur local en réponse à un signal de commande, et ce dispositif comprend :

- des moyens pour initialiser le signal de commande en fonction du signal de référence,
- des moyens d'estimation qui reçoivent le signal de transposition et le signal de commande pour produire répétitivement une estimation de ce décalage de fréquence, cette estimation se présentant comme la somme d'une valeur de correction et d'une valeur de réglage respectivement supérieure et inférieure à un seuil de correction prédéterminé,
- des moyens pour modifier le signal de commande en réponse à cette valeur de correction, et

- des moyens pour corriger le signal de transposition au moyen de l'une au moins de ces estimations successives.

L'optimisation du dispositif résulte d'une correction partagée entre l'oscillateur local et le processeur de signal.

Avantageusement, le signal de conversion pouvant présenter des fréquences discrètes régulièrement espacées d'une valeur d'ajustement, le seuil de correction est choisi égal à cette valeur d'ajustement.

De plus, cette valeur de correction est un multiple de la valeur d'ajustement.

Ainsi, le processeur de signal prend en charge la seule partie de la correction qui ne peut être réalisée au moyen de l'oscillateur local.

Par ailleurs, le dispositif réalise une première estimation au moyen d'un premier jeu de paramètres fonction du décalage maximum entre le signal de référence et le signal de réception, et il réalise ensuite une estimation ultérieure au moyen d'un second jeu de paramètres fonction du seuil de correction.

Ici, on tire profit du fait que l'estimation de décalage de fréquence est d'autant plus simple à réaliser que ce décalage est réduit.

De plus, des séquences différentes du signal de réception sont utilisées pour la première estimation et pour l'estimation ultérieure.

En effet, lorsque le décalage est déjà partiellement corrigé, la signalisation utilisée pour corriger ce décalage peut être réduite.

En outre, le signal de réception se présentant sous la forme d'une succession de paquets comprenant chacun une séquence d'apprentissage et une séquence de données, l'une des estimations est réalisée sur la séquence d'apprentissage pour corriger la séquence de données.

Dans ce cas, on tire le meilleur parti de la structure du signal de réception.

Selon une caractéristique additionnelle du dispositif, les estimations sont réalisées au moyen de la fonction d'autocorrélation d'une séquence connue d'un signal d'émission correspondant au signal de réception.

L'invention concerne également un procédé de correction d'un décalage de fréquence entre un signal de réception et un signal de conversion comprenant les étapes suivantes :

- une conversion du signal de réception au moyen d'un signal de conversion pour produire un signal de transposition;
- une première estimation du décalage de fréquence;
- une modification du signal de conversion en réponse à cette première estimation;
- une nouvelle estimation de l'écart résiduel de fréquence entre le signal de réception et le signal de conversion ainsi modifié; et
- une correction du signal de transposition au moyen de cet écart résiduel.

L'invention apparaîtra maintenant de manière plus précise dans le cadre d'exemples de réalisation donnés à titre illustratif en se référant aux figures annexées qui représentent :

- la figure 1, un agencement du dispositif de correction selon l'invention dans un récepteur,
- la figure 2, un mode de fonctionnement de ce dispositif,
- la figure 3, une caractéristique optionnelle du mode de fonctionnement précédent.

Les éléments identiques apparaissant dans plusieurs figures y seront référencés d'une seule manière.

On rappelle donc que l'on a choisi de se placer dans le cadre d'un système de radiocommunication pour présenter une application typique de l'invention.

Par ailleurs, pour conserver à cette application un caractère de généralité, on considérera le cas où les signaux traités sont de nature complexe, c'est-à-dire que la modulation se fait sur deux voies en quadrature de phase que l'on a coutume d'appeler voie I et voie Q.

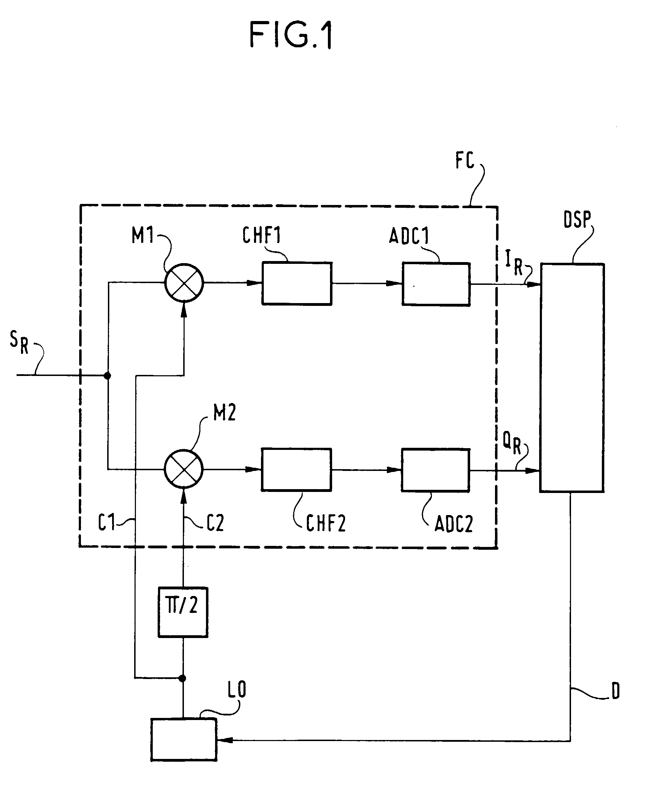

En référence à la figure 1, le récepteur comprend un convertisseur de fréquence FC pour le traitement de chacune des voies. On entend ici le terme convertisseur dans une acception très large bien qu'il puisse se réduire à un mélangeur.

Pour la voie I, ce convertisseur FC comprend un premier mélangeur M1 qui reçoit le signal de réception $S_R$ et un premier signal de conversion $c_1$. Il comprend également un premier filtre de canal CHF1 raccordé à la sortie du premier mélangeur M1, ce filtre étant suivi d'un premier convertisseur analogique-numérique ADC1 qui délivre des échantillons $I_R$ au rythme d'une fréquence d'échantillonnage $f_s$.

De même, pour la voie Q, le convertisseur de fréquence FC comprend un deuxième mélangeur M2 qui reçoit également le signal de réception $S_R$ et un deuxième signal de conversion $C_2$. Il comprend aussi un deuxième filtre de canal CHF2 raccordé à la sortie du deuxième mélangeur M2, ce filtre étant suivi d'un deuxième convertisseur analogique-numérique ADC2 qui délivre des échantillons $Q_R$ au rythme de la fréquence d'échantillonnage $f_s$.

La réunion des échantillons $I_R$ et $Q_R$ forment le signal de transposition.

Il apparaît qu'on a choisi d'adopter la technologie numérique dans le cadre de cette réalisation car il s'agit d'une technologie maintenant couramment employée dont les avantages ne sont plus à démontrer. De ce fait, le dispositif de correction d'un décalage de fréquence sera réalisé au moyen d'un processeur numérique de signal DSP qui pourra par ailleurs être employé à d'autres fins.

Ce processeur DSP reçoit donc les échantillons $I_R$ et $Q_R$. Il fournit de plus un signal de commande D dont la nature sera détaillée ultérieurement.

Le récepteur comprend en outre un oscillateur local LO tel qu'un synthétiseur de fréquence qui produit le premier signal de conversion C1 en réponse au signal de commande D.

Ce premier signal de conversion C1 est également injecté sur un déphaseur $\pi/2$ pour donner naissance au second signal de conversion C2.

Le dispositif de correction DSP a donc pour fonction de corriger le décalage de fréquence entre le signal de réception $S_R$ et un signal de référence dont la valeur est enregistrée dans une mémoire (non représentée) interne ou externe.

En préalable à cette correction, il faut réaliser une estimation de décalage. Pour ce faire, on peut utiliser une méthode dérivée de celle qui est employée dans le domaine du radar, telle que celle qui est présentée dans le polycopié de l'école "SUPELEC" n°3113 de 1986 : Théorie de la détection et de l'estimation, Application au Radar, Jean-Marie COLIN.

Selon cette méthode, si l'on note $S_E(t)$ le signal d'émission produit par l'émetteur, $S_R(t)$ le signal de réception, $f_d$ le décalage de fréquence et $\hat{f}_d$ une estimation de ce décalage, alors la meilleure estimation rend maximale l'intégrale Int :

$$Int = \int S_E^*(t) S_R(t) e^{-j2\pi\hat{f}_d t} \, dt$$

Par une convention courante, $s_E*(t)$ représente la valeur conjuguée de $S_E(t)$.

Naturellement, le signal d'émission $S_E(t)$ est connu du récepteur où il est enregistré.

L'intégrale Int précédente se transpose aisément en une somme Sig lorsque la variable temps passe de la nature continue à la nature discrète, ce qui correspond bien au cas de signaux numériques. Dans ce cas, en faisant l'hypothèse que la durée $T_s$ des symboles du signal d'émission soit égale à l'inverse de la fréquence d'échantillonnage $f_s$, un de ces symboles $S_E(kT_S)$ se présente comme la somme d'une partie réelle $I_E(kT_S)$ et d'une partie imaginaire $Q_E(kT_S)$ :

$$S_E(kT_S) = I_E(kT_S) + j Q_E(kT_S)$$

En faisant l'hypothèse supplémentaire que le signal de transposition est en bande de base, alors un échantillon $S_R(kT_S)$ correspondant de ce signal se présente de manière analogue :

$$S_R(kT_S) = I_R(kT_S) + j Q_R(kT_S)$$

Si l'on considère N symboles consécutifs alors la somme Sig peut s'écrire :

$$Sig(\hat{f}_d) = \sum_{k=0}^{N-1} S_E^*(kT_S) \, S_R(kT_S) e^{-j2\pi\hat{f}_d kT_S}$$

$$\mathrm{Sig}(\hat{f}_d) = \sum_{k=0}^{N-1} \left[ I_E(kT_S) I_R(kT_S) + Q_E(kT_S) Q_R(kT_S) \right] \cos\left(2\pi\hat{f}_d kT_S\right)$$

$$+ \left[ I_E(kT_S) Q_R(kT_S) - Q_E(kT_S) I_R(kT_S) \right] \sin\left(2\pi\hat{f}_d kT_S\right)$$

$$- j\left[ I_E(kT_S) I_R(kT_S) + Q_E(kT_S) Q_R(kT_S) \right] \sin\left(2\pi\hat{f}_d kT_S\right)$$

$$+ j\left[ I_E(kT_S) Q_R(kT_S) - Q_E(kT_S) I_R(kT_S) \right] \cos\left(2\pi\hat{f}_d kT_S\right)$$

Lorsque $\hat{f}_d$ est la meilleure estimation de $f_d$ et si le signal de réception n'est pas affecté par la transmission, alors :

$$s_E(kT_S) = s_R(kT_S) e^{-j2\pi\hat{f}_d kT_S}$$

Il s'ensuit que Sig est la fonction d'autocorrélation du signal d'émission et correspond à l'énergie de ce signal.

La somme sig($\hat{f}_d = f_d$) est donc une valeur réelle et maximale.

Dans la pratique, $\hat{f}_d$ doit prendre des valeurs discrètes et une solution avantageuse consiste à choisir $\hat{f}_d$ comme un multiple d'un écart élémentaire $\Delta f$ :

$$\hat{f}_d = p\Delta f$$

Si le décalage de fréquence $f_d$ est inclus dans l'intervalle $f_1$, $f_2$, alors p variera de $p_1$ à $p_2$ de sorte que :

- $p_1 \Delta f \leq f_1 < (p_1+1)\Delta f$,
- $(p_2 - 1) \Delta f < f_2 \leq p_2 \Delta f$

Le dispositif de correction ne sera pas décrit dans sa structure car il met en oeuvre les opérations élémentaires bien connues de l'homme du métier telles que addition, multiplication, comparaison. Comme par ailleurs il a été choisi de l'implémenter dans un processeur, une description fonctionnelle semble de loin préférable pour expliciter la mise en oeuvre de l'invention.

En remplaçant donc $\hat{f}_d$ par $p\cdot\Delta f$ on peut écrire :

$$\mathrm{Sig}(\hat{f}_d) = \mathrm{Sig}(p\Delta f)$$

La somme précédente comprend une partie réelle $A_p$ et une partie imaginaire $B_p$ :

$$\mathrm{Sig}(p\,\Delta f) = A_p + j\,B_p,$$

avec

$$A_p = \sum_{k=0}^{N-1} \left[ I_E\left(kT_S\right)I_R\left(kT_S\right) + Q_E\left(kT_S\right)Q_R\left(kT_S\right) \right] \cos\left(2\pi\hat{f}_d kT_S\right)$$

$$+ \left[ I_E\left(kT_S\right)Q_R\left(kT_S\right) - Q_E\left(kT_S\right)I_R\left(kT_S\right) \right] \sin\left(2\pi\hat{f}_d kT_S\right)$$

$$B_p = \sum_{k=0}^{N-1} - \left[ I_E\left(kT_S\right)I_R\left(kT_S\right) + Q_E\left(kT_S\right)Q_R\left(kT_S\right) \right] \sin\left(2\pi\hat{f}_d kT_S\right)$$

$$+ \left[ I_E\left(kT_S\right)Q_R\left(kT_S\right) - Q_E\left(kT_S\right)I_R\left(kT_S\right) \right] \cos\left(2\pi\hat{f}_d kT_S\right)$$

Comme on l'a vu précédemment, il convient de rechercher l'annulation de la partie imaginaire B de Sig qui coincïde avec un changement de signe. On va donc considérer deux couples successifs $(A_p, B_p)$, $(A_{p+1}, B_{p+1})$ que l'on conviendra d'appeler respectivement dernier couple calculé identifié par l'indice $\ell$ $(A_\ell = A_p, B_\ell = B_p)$ et nouveau couple identifié par l'indice n $(A_n = A_{p+1}, B_n = B_{p+1})$.

Il faut également rechercher le maximum de la partie réelle de Sig et on le nommera $A_M$.

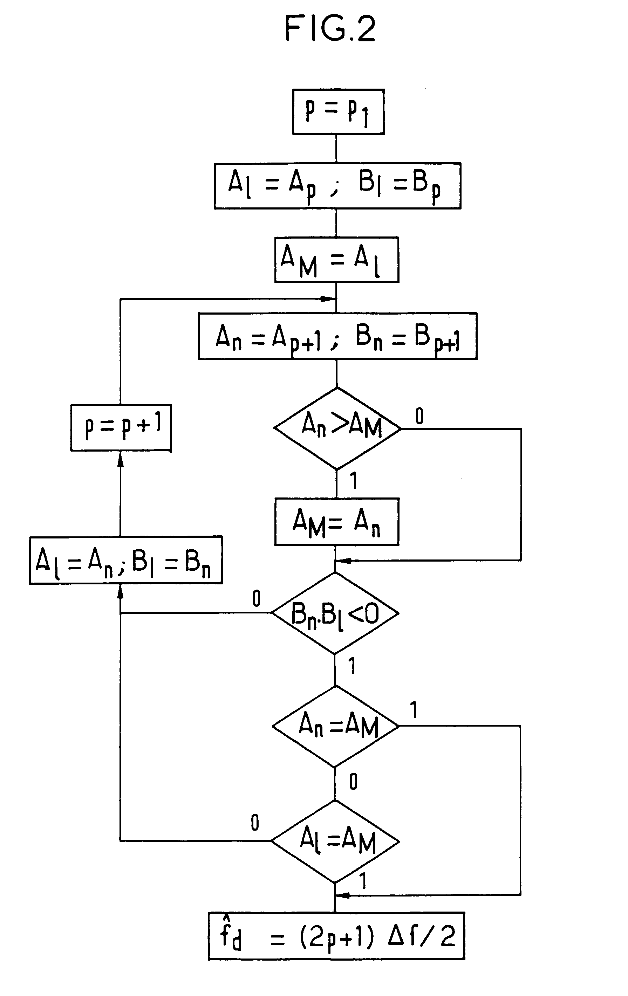

En référence à la figure 2, le dispositif de correction effectue donc la succession des opérations suivantes :

a) initialisation de l'indice p par $p_1$;

b) calcul du couple $(A_{p1}, B_{p1})$ correspondant aux premiers échantillons reçus et affectation de ces valeurs au dernier couple $(A_\ell, B_\ell)$;

c) initialisation du maximum $A_M$ par $A_\ell$;

d) calcul du couple suivant $(A_{p+1}, B_{p+1})$ et affectation de ces valeurs au nouveau couple $(A_n, B_n)$;

e) suivi du maximum de la partie réelle :

si $A_n$ est supérieur $A_M$, alors affecter la valeur de $A_n$ à $A_M$, sinon passer à l'opération suivante;

f) recherche de l'inversion de signe de la partie imaginaire :

si le produit de $B_n$ et $B_\ell$ est négatif passer à l'opération suivante, sinon passer à l'opération h;

g) recherche du maximum de la partie réelle A :

si $A_n$ ou $A_\ell$ valent $A_M$, alors on a bien encadré le maximum et l'estimation du décalage de fréquence $\hat{f}_d$ vaut :

$$\hat{f}_d = (2p+1)\Delta f/2$$

sinon passer à l'opération suivante;

h) affectation des valeurs du nouveau couple $(A_n, B_n)$ au dernier couple $(A_\ell, B_\ell)$, incrémentation de l'indice p d'une unité et reprise de l'opération d.

On remarquera qu'il n'est pas nécessaire de faire toutes les opérations pour un couple $(A_p, B_p)$ si la valeur de $A_p$ est très faible.

On peut ainsi déterminer un seuil $A_S$ de manière empirique ou par simulation en deçà duquel il n'est pas possible que $A_p$ approche la valeur maximale.

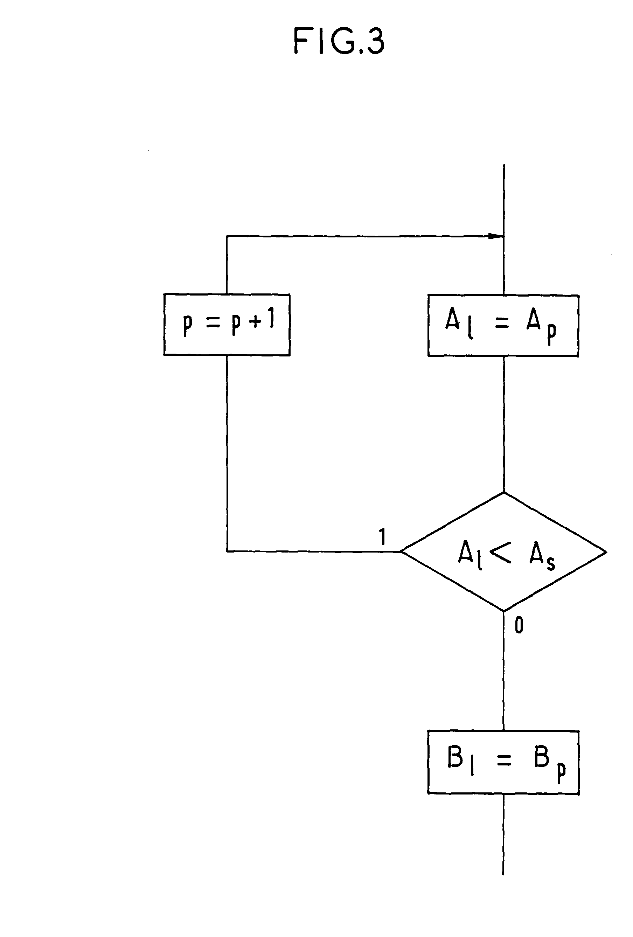

Ainsi, à titre optionnel, en référence à la figure 3, on peut remplacer l'opération b précédemment décrite par la suite des opérations suivantes avant de reprendre à l'opération c :

$b_1$) calcul de la partie réelle $A_p$ et affectation de cette valeur à la variable $A_\ell$;

$b_2$) recherche de dépassement du seuil :

si $A_\ell$ est inférieur à $A_S$ incrémenter p d'une unité et passer à l'opération $b_1$, sinon calcul de la partie imaginaire $B_p$ et affectation de cette valeur à la variable $B_\ell$ puis passer à l'opération c.

Pour produire l'estimation $\hat{f}_d$ du décalage de fréquence $f_d$, on rappelle que le dispositif de correction a besoin des données suivantes :

- un paquet de N symboles du signal d'émission $S_E$;
- un paquet de N couples d'échantillons correspondant du signal de transposition;
- valeur de l'écart élémentaire de fréquence $\Delta f$;
- valeur initiale $p_1$ de l'indice p.

Selon une première variante du dispositif de correction, celui-ci produit le signal de commande D de sorte que le synthétiseur LO produise les signaux de conversion C1, C2 à une fréquence voisine de celle du signal de référence. En effet on prévoit que le synthétiseur soit à commande discrète et sa fréquence ne peut donc être modifiée que par augmentation ou par diminution d'un multiple d'une valeur d'ajustement $V_f$.

Le dispositif procède alors à l'estimation $\hat{f}_d$ du décalage de fréquence $f_d$ comme exposé auparavant.

Il recherche ensuite l'incrément q qu'il convient d'appliquer au synthétiseur pour qu'il compense grossièrement le décalage de fréquence :

$$\left(q - \frac{1}{2}\right)V_f \leq \hat{f}_d < \left(q + \frac{1}{2}\right)V_f$$

Il commande ensuite le synthétiseur pour qu'il décale sa fréquence d'une valeur égale ou produit de l'incrément q par la valeur d'ajustement $V_f$.

Dès lors, deux options sont possibles. Selon la première option, on effectue la correction du décalage de fréquence.

A cette fin, on fait l'hypothèse que celui-ci est constant pendant toute la durée du paquet d'échantillons, si bien que l'écart de phase $\varphi$ entre deux échantillons consécutifs qui est dû à ce décalage de fréquence est constant et vaut :

$$\varphi = 2\pi . \hat{f}_d . T_S$$

Il s'agit donc de corriger la phase de chaque couple d'échantillons en conséquence. On admet que la correction à apporter au milieu du paquet d'échantillons est nulle, ce qui revient simplement, si tel n'était pas le cas, à déplacer tous les échantillons d'une même valeur.

A titre d'exemple, si N est impair, l'indice k d'un couple d'échantillons variant de 0 à (N-1) le couple d'indice (N-1)/2 ne sera donc pas corrigé. D'autre part on remarque que les corrections sont symétriques de part et d'autre du milieu du paquet, c'est-à-dire que la correction de phase à apporter au couple d'indice (N-1-k) est l'opposée de celle à appliquer au couple d'indice k.

Le dispositif de correction calcule donc un ensemble de valeurs de réglages REG(k), pour tout k variant de 0 à (N-3)/2 :

$$REG(k) = e^{-j[(N-1)/2-k]\varphi}$$

Chacune de ces valeurs de réglages REG(k) comprend une partie réelle U(k) et une partie imaginaire V(k) : :

$$REG(k) = U(k) + j\, V(k),$$

avec

$$U(k) = \cos[(N-1)/2 - k]\,\varphi$$

$$V(k) = -\sin[(N-1)/2 - k]\,\varphi$$

Le dispositif produit alors les échantillons corrigés $I'_R$, $Q'_R$ comme suit :

- pour k < (N-1)/2

  - $I'_R(kT_S) = I_R(kT_S) \cdot U(k) - Q_R(kT_S) \cdot V(k)$
  - $Q'_R(kT_S) = I_R(kT_S) \cdot V(k) + Q_R(kT_S) \cdot U(k)$

- pour k = (N-1)/2

  - $I'_R(kT_S) = I_R(kT_S)$
  - $Q'_R(kT_S) = Q_R(kT_S)$

- pour k > (N-1)/2

  - $I'_R(kT_S) = I_R(kT_S) \cdot U(k) + Q_R(kT_S) \cdot V(k)$
  - $Q'_R(kT_S) = - I_R(kT_S) \cdot V(k) + Q_R(kT_S) \cdot U(k)$

Selon la deuxième option, les échantillons du signal de transposition ($I_R$, $Q_R$) ne sont pas corrigés et on attend qu'un nouveau paquet d'échantillons de ce signal soit reçu. Le synthétiseur de fréquence LO ayant déjà été corrigé en fréquence, le décalage de fréquence est donc sensiblement réduit. Sur ce nouveau paquet on peut alors faire la correction en considérant la valeur précédente de l'estimation $\hat{f}_d$, c'est-à-dire en remplaçant dans l'écart de phase $\varphi$ le terme $\hat{f}_d$ par ($\hat{f}_d$ - q.Vf) ou bien alors on peut procéder à une nouvelle estimation $\hat{f}'_d$ du décalage de fréquence avant de faire la correction à partir de cette nouvelle estimation.

De plus, si celle-ci $\hat{f}'_d$ est supérieure en valeur absolue à la valeur d'ajustement Vf, on corrige le synthétiseur LO en conséquence.

On procède naturellement de la même manière pour les paquets suivants.

Il apparaît que quelle que soit l'option retenue on va faire une estimation du décalage de fréquence entre le signal de réception et la fréquence implicitement contenue dans le signal de commande D, celle qui correspond aux signaux de conversion C1, C2 qui ont engendré les échantillons $I_R$, $Q_R$ sur lesquels portent cette estimation.

Lors de la première estimation, le signal de commande est initialisé au moyen du signal de référence et il est ensuite modifié en fonction des estimations successives.

Au vu de ce qui précède, on peut distinguer deux phases dans la correction de fréquence.

Lors de la première phase qui correspond au premier paquet par exemple, le décalage de fréquence $f_d$ n'est pas connu et il peut varier dans une large mesure. Par contre, il n'est pas nécessaire de le connaître avec une précision meilleure que la valeur d'ajustement Vf du synthétiseur LO.

Lors de la deuxième phase qui correspond aux paquets suivants, le décalage de fréquence est sensiblement réduit et ne peut pas excéder notablement la valeur d'ajustement Vf. Par contre, il est nécessaire de le connaître avec une bonne précision pour que la correction soit la plus efficace possible.

Ainsi, selon une seconde variante du dispositif de l'invention, celui-ci procède tout d'abord à une estimation grossière du décalage de fréquence $f_d$ à l'aide d'un premier jeu de paramètres pour corriger le synthétiseur LO, et il procède ensuite à une estimation plus fine à l'aide d'un second jeu de paramètres pour corriger la phase des échantillons ($I_R$, $Q_R$) du signal de transposition. De plus le décalage de fréquence est toujours contrôlé pour réajuster éventuellement le synthétiseur LO.

Afin d'illustrer cette variante, on se placera dans le cadre du GSM qui fait appel à des paquets de signalisation et à des paquets dits "normaux" utilisés pour le trafic. Au nombre des paquets de signalisation, figure un paquet dit "Frequency burst" formé de 156 symboles connus.

C'est ce paquet qui sera utilisé pour l'estimation grossière. Il faut déterminer la valeur de l'écart élémentaire de fréquence $\Delta f$. En supposant que la valeur d'ajustement $V_f$ du synthétiseur LO soit de 5 kHz, on pourrait retenir cette valeur. Cependant, il y aurait un risque de ne pas détecter le décalage de fréquence. On préfère donc prendre une valeur inférieure, 1,5 kHz par exemple, pour l'écart élémentaire $\Delta f$. En conséquence, si le décalage de fréquence peut varier entre - 45 kHz et + 45 kHz, il faudra donner la valeur - 15 à $p_1$ et il pourra être nécessaire d'effectuer jusqu'à 31 calculs pour l'estimation terme $f_d$ de décalage de fréquence car p varie de - 15 à + 15.

On définit ainsi une première série de paramètres pour l'estimation grossière qui comprend un grand nombre d'échantillons, mais qui présente un écart élémentaire de fréquence $\Delta f$ relativement élevé :

- N = 156 symboles du signal d'émission;
- N = 156 couples d'échantillons ($I_R$, $Q_R$) du signal de transposition;
- écart élémentaire de fréquence $\Delta f$ = 1,5 kHZ;
- valeur initiale de l'indice p : $p_1$ = - 15.

Il n'est bien entendu pas nécessaire de corriger ces échantillons.

Suite à cette estimation grossière, le synthétiseur LO est corrigé comme déjà mentionné.

Le décalage de fréquence est maintenant sensiblement compris dans l'intervalle - 2,5 kHz, + 2,5 kHz.

L'estimation fine de décalage de fréquence peut se faire sur un nombre beaucoup plus réduit d'échantillons. On choisira 24 des 26 symboles de la séquence d'apprentissage d'un "normal burst", ce qui présente l'avantage de ne pas recourir à un paquet de signalisation spécifique.

Ainsi on utilise les symboles connus du paquet pour faire l'estimation, alors que la correction portera essentiellement sur les symboles de données qui supportent l'information véhiculée par ce paquet.

En supposant que la précision requise sur l'estimation $\hat{f}_d$ soit de 150 Hz, il faut donc fixer la valeur de l'écart élémentaire de fréquence $\Delta f$ à 300 Hz.

En recherchant le décalage de fréquence entre - 2,7 kHz et + 2,7 kHz, il vient que $p_1$ doit être fixé à - 9 et il pourra être nécessaire d'effectuer jusqu'à 19 calculs pour l'estimation $\hat{f}_d$ du décalage de fréquence car p varie de - 9 à + 9.

On définit ainsi une deuxième série de paramètres pour l'estimation fine qui comprend un nombre d'échantillons réduit mais qui présente un écart élémentaire de fréquence $\Delta f$ également plus faible :

- N = 24 symboles de données;
- N = 24 couples d'échantillons ($J_R$, $Q_R$) du signal de transposition;
- écart élémentaire de fréquence $\Delta f$ = 300 Hz;
- valeur initiale de l'indice p : $p_1$ = -9.

Nautrellement, si $\hat{f}_d$ est inférieur à - 2,5 kHz ou supérieur à + 2,5 kHz, le dispositif de correction commande le synthétiseur LO de sorte que le décalage de fréquence soit ramené dans l'intervalle correspondant.

Il va sans dire que l'invention n'est pas limitée aux modes de réalisation qui ont fait l'objet d'une description détaillée. L'homme du métier comprend bien qu'elle vise également bien d'autres applications.

**Revendications**

1. Dispositif de correction d'un décalage de fréquence entre un signal de réception et un signal de référence, ce signal de réception ($S_R$) étant soumis à un convertisseur de fréquence (FC) qui reçoit également un signal de conversion (C1, C2) pour produire un signal de transposition ($I_R$, $Q_R$), ce signal de conversion (C1, C2) étant produit par un oscillateur local (LO) en réponse à un signal de commande (D), caractérisé en ce qu'il comprend :

   - des moyens pour initialiser ledit signal de commande (D) en fonction dudit signal de référence,
   - des moyens d'estimation qui reçoivent ledit signal de transposition ($I_R$, $Q_R$) et ledit signal de commande (D) pour produire répétitivement une estimation ($\hat{f}_d$) dudit décalage de fréquence, cette estimation ($\hat{f}_d$) se présentant comme la somme d'une valeur de correction et d'une valeur de réglage respectivement supérieure et inférieure à un seuil de correction prédéterminé,
   - des moyens pour modifier ledit signal de commande (D) en réponse à ladite valeur de correction, et
   - des moyens pour corriger ledit signal de transposition ($I_R$, $Q_R$) au moyen de l'une au moins desdites estimations ($\hat{f}_d$) successives.

2. Dispositif selon la revendication 1, caractérisé en ce que, ledit signal de conversion (C1, C2) pouvant présenter des fréquences discrètes régulièrement espacées d'une valeur d'ajustement ($V_f$), ledit seuil de correction est choisi égal à cette valeur d'ajustement ($V_f$).

3. Dispositif selon la revendication 2, caractérisé en ce que ladite valeur de correction est un multiple de ladite valeur d'ajustement ($V_f$).

4. Dispositif selon l'une quelconque des revendications 1 à 3, caractérisé en ce qu'il réalise une première estimation ($\hat{f}_d$) au moyen d'un premier jeu de paramètres fonction du décalage maximum entre ledit signal de référence et ledit signal de réception ($S_R$) et en ce qu'il réalise ensuite une estimation ultérieure ($\hat{f}'_d$) au moyen d'un second jeu de paramètres fonction dudit seuil de correction.

5. Dispositif selon la revendication 4, caractérisé en ce que des séquences différentes dudit signal de réception ($S_R$) sont utilisées pour ladite première ($\hat{f}_d$) estimation et pour ladite estimation ultérieure ($\hat{f}'_d$).

**6.** Dispositif selon l'une quelconque des revendications 4 ou 5, caractérisé en ce que, ledit signal de réception ($S_R$) se présentant sous la forme d'une succession de paquets comprenant chacun une séquence d'apprentissage et une séquence de données, l'une desdites estimations est réalisée sur ladite séquence d'apprentissage pour corriger ladite séquence de données.

**7.** Dispositif selon l'une quelconque des revendications 1 à 6, caractérisé en ce que lesdites estimations ($\hat{f}_d$) sont réalisées au moyen de la fonction d'autocorrélation d'une séquence connue d'un signal d'émission correspondant audit signal de réception ($S_R$).

**8.** Procédé de correction d'un décalage de fréquence entre un signal de réception ($S_R$) et un signal de conversion (C1, C2) comprenant les étapes suivantes :

- une conversion dudit signal de réception ($S_R$) au moyen d'un signal de conversion (C1, C2) pour produire un signal de transposition ($I_R$, $Q_R$);
- une première estimation ($\hat{f}_d$) dudit décalage de fréquence;
- une modification dudit signal de conversion (C1, C2) en réponse à cette première estimation ($\hat{f}_d$);
- une nouvelle estimation ($\hat{f}'_d$) de l'écart résiduel de fréquence entre ledit signal de réception ($S_R$) et ledit signal de conversion ainsi modifié (C1, C2); et
- une correction dudit signal de transposition ($I_R$, $Q_R$) au moyen dudit écart résiduel.

## Patentansprüche

**1.** Vorrichtung zur Korrektur einer Frequenzverschiebung zwischen einem Empfangssignal und einem Bezugssignal, wobei das Empfangssignal ($S_R$) einem Freuqenzwandler (FC) unterworfen wird, der auch ein Umwandlungssignal (C1, C2) empfängt, um ein Verlagerungssignal ($I_R$, $Q_R$) zu erzeugen, wobei dieses Umwandlungssignal C1, C2 von einem Lokaloszillator (LO) in Antwort auf eine Steuersignal (D) erzeugt wird, dadurch gekennzeichnet, daß sie umfaßt:

- Mittel zum Initialisieren des Steuersignals (D) in Abhängigkeit vom Bezugssignal,
- Schätzmittel, die das Verlagerungssignal ($I_R$, $Q_R$) und das Steuersignal (D) empfangen, im wiederholt eine Schätzung ($\hat{f}_d$) der Frequenzverschiebung zu erzeugen, wobei sich diese Schätzung ($\hat{f}_d$) als Summe eines Korrekturwertes und eines Regelungswertes zeigt, die größer bzw. kleiner als eine vorbestimmte Korrekturschwelle sind,
- Mittel zum Modifizieren des Steuersignals (D) in Antwort auf den Korrekturwert und
- Mittel zum Korrigieren des Verlagerungssignals ($I_R$, $Q_R$) mittels wenigstens einer der aufeinanderfolgenden Schätzungen ($\hat{f}_d$)

**2.** Vorrichtung nach Anspruch 1, dadurch gekennzeichnet, daß wenn das Umwandlungssignal (C1, C2) diskrete Frequenzen mit einem regelmäßigen Abstand von einem Einstellwert ($V_f$) aufweisen kann, die Korrekturschwelle gleich diesem Einstellwert ($V_f$) gewählt wird.

**3.** Vorrichtung nach Anspruch 2, dadurch gekennzeichnet, daß der Korrekturwert ein Vielfaches des Einstellwertes ($V_f$) ist.

**4.** Vorrichtung nach einem der Ansprüche 1 bis 3, dadurch gekennzeichnet, daß sie eine erste Schätzung ($\hat{f}_d$) mittels eines ersten Satzes von Parametern ausführt, der von der maximalen Verschiebung zwischen dem Bezugssignal und dem Empfangssignal ($S_R$) abhängt, und daß sie dann eine spätere Schätzung ($\hat{f}_d$) mittels eines zweiten Satzes von Parametern ausführt, der von der Korrekturschwelle abhängt.

**5.** Vorrichtung nach Anspruch 4, dadurch gekennzeichnet, daß die verschiedenen Folgen des Empfangssignals ($S_R$) für die erste Schätzung ($\hat{f}_d$) und für die spätere Schätzung ($\hat{f}'_d$) verwendet werden.

**6.** Vorrichtung nach einem der Ansprüche 4 oder 5, dadurch gekennzeichnet, daß wenn sich das Empfangssignal ($S_R$) in Form einer Folge von Paketen zeigt, die jeweils eine Übungsfolge und eine Datenfolge aufweisen, eine der Schätzungen auf der Übungsfolge ausgeführt wird, um die Datenfolge zu korrigieren.

**7.** Vorrichtung nach einem der Ansprüche 1 bis 6, dadurch gekennzeichnet, daß die Schätzungen ($\hat{f}_d$) mittels der Autokorrelationsfunktion einer bekannten Folge eines Sendesignals ausgeführt wird, das dem Empfangssignal ($S_R$) entspricht.

**8.** Verfahren zur Korrektur einer Frequenzverschiebung zwischen einem Empfangssignal ($S_R$) und einem Umwandlungssignal (C1, C2), das die folgenden Schritte umfaßt:

- eine Umwandlung des Empfangssignals ($S_R$) mittels eines Umwandlungssignals (C1, C2), um ein Verlagerungssignal ($I_R$, $Q_R$) zu erzeugen;
- eine erste Schätzung ($\hat{f}_d$) der Frequenzverschiebung;
- eine Modifikation des Umwandlungssignals (C1, C2) in Antwort auf diese erste Schätzung ($\hat{f}_d$);
- eine neue Schätzung ($\hat{f}'_d$) der restlichen Frequenzabweichung zwischen dem Empfangssignal ($S_R$) und dem so modifizierten Umwandlungssignal (C1, C2); und
- eine Korrektur des Verlagerungssignals ($I_R$, $Q_R$) mittels der restlichen Abweichung.

**Claims**

**1.** Device for correcting a frequency offset between a receive signal and a reference signal, said receive signal ($S_R$) being fed to a frequency converter (FC) which also receives a conversion signal (C1, C2) in order to produce a transposed signal ($I_R$, $Q_R$), said conversion signal (C1, C2) being produced by a local oscillator (LO) in response to a control signal (D), characterized in that it comprises:

- means for initializing said control signal (D) according to said reference signal,
- estimator means which receive said transposed signal ($I_R$, $Q_R$) and said control signal (D) to produce repetitively an estimate ($\hat{f}_d$) of said frequency offset, said estimate ($\hat{f}_d$) comprising the sum of a correction value and an adjustment value respectively greater than and less than a predetermined correction threshold,
- means for modifying said control signal (D) in response to said correction value, and
- means for correcting said transposed signal ($I_R$, $Q_R$) by means of at least one of said successive estimates ($\hat{f}_d$).

**2.** Device according to claim 1, characterized in that said conversion signal (C1, C2) possibly comprising discrete frequencies regularly spaced by an adjustment value ($V_f$), said correction threshold is chosen equal to said adjustment value ($V_f$).

**3.** Device according to claim 2, characterized in that said correction value is a multiple of said adjustment value ($V_f$).

**4.** Device according to any one of claims 1 to 3, characterized in that it effects a first estimate ($\hat{f}_d$) by means of a first set of parameters dependent on the maximum offset between said reference signal and said receive signal ($S_R$) and then effecting a subsequent estimate ($\hat{f}'_d$) by means of a said second set of parameters dependent on said correction threshold.

**5.** Device according to claim 4, characterized in that different sequences of said receive signal ($S_R$) are used for said first estimate ($\hat{f}_d$) and for said subsequent estimate ($\hat{f}'_d$).

**6.** Device according to claim 4 or claim 5, characterized in that said receive signal ($S_R$) being in the form of a succession of bursts each comprising a training sequence and a data sequence, one of said estimates is effected on said training sequence to correct said data sequence.

**7.** Device according to any one of claims 1 to 6, characterized in that said estimates ($\hat{f}_d$) are obtained by means of the autocorrelation function of a known sequence of a transmit signal corresponding to said receive signal ($S_R$).

**8.** Method of correcting a frequency offset between a receive signal ($S_R$) and a conversion signal (C1, C2) comprising the following steps:

- conversion of said receive signal ($S_R$) by means of a conversion signal (C1, C2) to produce a transposed signal ($I_R$, $Q_R$);
- a first estimate ($\hat{f}_d$) of said frequency offset;
- modification of said conversion signal (C1, C2) in response to said first estimate ($\hat{f}_d$);
- a new estimate ($\hat{f}'_d$) of the residual frequency offset between said receive signal ($S_R$) and said conversion signal (C1, C2) modified in this way; and

- correction of said transposed signal ($I_R$, $Q_R$) by means of said residual offset.

# FIG.1

# FIG.2

$$p = p_1$$

$$A_l = A_p \; ; \quad B_l = B_p$$

$$A_M = A_l$$

$$A_n = A_{p+1} \; ; \quad B_n = B_{p+1}$$

$$A_n > A_M \quad 0$$

$$1$$

$$A_M = A_n$$

$$p = p + 1$$

$$B_n \cdot B_l < 0 \quad 0$$

$$A_l = A_n \; ; \quad B_l = B_n$$

$$1$$

$$A_n = A_M \quad 1$$

$$0$$

$$A_l = A_M \quad 0$$

$$1$$

$$\hat{f}_d = (2p+1) \, \Delta f / 2$$

# FIG.3

$$p = p + 1$$

$$A_l = A_p$$

$$A_l < A_s$$

1

0

$$B_l = B_p$$